Europäisches Patentamt

European Patent Office

Office européen des brevets

(11) Veröffentlichungsnummer : **0 332 070 B1**

(12) **EUROPÄISCHE PATENTSCHRIFT**

(45) Veröffentlichungstag der Patentschrift :
**15.02.95 Patentblatt 95/07**

(51) Int. Cl.⁶ : **G03F 7/32**

(21) Anmeldenummer : **89103741.8**

(22) Anmeldetag : **03.03.89**

(54) **Verfahren zum Entwickeln von bildmässig belichteten Flexodruckplatten.**

(30) Priorität : **10.03.88 DE 3807929**

(43) Veröffentlichungstag der Anmeldung :
**13.09.89 Patentblatt 89/37**

(45) Bekanntmachung des Hinweises auf die
Patenterteilung :
**15.02.95 Patentblatt 95/07**

(84) Benannte Vertragsstaaten :
**BE CH DE FR GB IT LI NL**

(56) Entgegenhaltungen :
**GB-A- 1 189 944**
**US-A- 3 887 373**
**PATENT ABSTRACTS OF JAPAN, Band 8, Nr.**
**278 (P-322)[1715], 19. Dezember 1984; &**
**JP-A-59 146 054**

(73) Patentinhaber : **BASF Aktiengesellschaft**
**Carl-Bosch-Strasse 38**
**D-67063 Ludwigshafen (DE)**

(72) Erfinder : **Telser, Thomas, Dr.**
**Kurpfalzstrasse 9**
**D-6905 Schriesheim (DE)**
Erfinder : **Koch, Horst, Dr.**
**Tiefenthaler Strasse 47**
**D-6718 Gruenstadt (DE)**
Erfinder : **Kurtz, Karl-Rudolf, Dr.**
**Schloss-Wolfs-Brunnen-Weg 62**
**D-6900 Heidelberg (DE)**
Erfinder : **Bach, Helmut, Dr.**
**Dahlienstrasse 7**
**D-6704 Mutterstadt (DE)**
Erfinder : **Werther, Heinz-Ulrich, Dr.**
**Hans-Hoffmann-Strasse 12**
**D-6706 Wachenheim (DE)**

## Beschreibung

Die Erfindung betrifft ein Verfahren zum Entwickeln von bildmäßig belichteten Flexodruckplatten, wobei zum Auswaschen der unvernetzten Anteile der Schichten bestimmte Entwicklerlösungsmittel verwendet werden.

Die Herstellung von Druckformen durch bildmäßiges Belichten von photopolymerisierbaren oder photovernetzbaren reliefbildenden Schichten mit aktinischem Licht unter Vernetzung der belichteten Schichtanteile und anschließendes Auswaschen der unvernetzten Anteile der Schichten in Entwicklerlösemitteln ist bekannt. Üblicherweise werden dabei als Entwicklerlösemittel chlorierte Kohlenwasserstoffe wie z.B. Trichlorethylen, Tetrachlorethylen, aromatische Kohlenwasserstoffe wie Benzol, Toluol, gesättigte cyclische und acyclische Kohlenwasserstoffe wie Hexan, Cyclohexan, ungesättigte cyclische Kohlenwasserstoffe wie z.B. terpenoide Verbindungen, Limonen, Pinen, niedere aliphatische Ketone wie Aceton, Methylethylketon, gegebenenfalls im Gemisch mit einem Alkohol (z.B. Butanol mit einem Anteil von ca. 20 Vol.-%) eingesetzt.

Die im Markt vielfach eingesetzte Auswaschlösung für Flexodruckplatten aus etwa 80 Vol.-Teilen Tetrachlorethylen und 20 Vol.-Teilen n-Butanol bzw. Trichlorethan verursacht durch ihre Toxizität Probleme beim Betrieb der Waschgeräte. So ist für einen ordnungsgemäßen Betrieb eine Absaugung notwendig, und die Abluft muß vor der Freisetzung von den chlorierten Kohlenwasserstoffen befreit werden. Auch die Entsorgung der gebrauchten Auswaschlösung gestaltet sich problematisch. Weitere Probleme ergeben sich durch die hohe Quellung, die die belichtete Schicht während des Auswaschens erfährt. Die hohe Quellung der Schicht verursacht Schäden an den photopolymerisierten Strukturen (Ausbrüche, Ablösen feiner Elemente etc.) sowie eine geringe Resistenz gegen Überwaschung.

In der US-A-3,887,373 wird ein Verfahren zum Entwickeln eines bildmäßig belichteten Photoresists, der cyclisiertes Polyisopren und 2,6-bis(p-azido-benzyliden)-4-methylcyclohexanon enthält, mit Naphtha- oder Cyclohexan-Lösungsmitteln beschrieben. Diese Entwicklerlösungsmittel enthalten mindestens 2 Vol.-% an Aromaten.

Dem Einsatz alternativer Auswaschmittel, wie den aromatischen und aliphatischen Kohlenwasserstoffen, stehen Probleme der Brennbarkeit entgegen. Diese Lösungsmittel weisen Flammpunkte unter 21°C auf und müssten folglich in explosionsgeschützten Anlagen betrieben werden. Das gilt auch für die niedermolekularen Lösemittel aus der Gruppe der Ketone.

Terpenoide Kohlenwasserstoffe, wie z.B. Limonen, besitzen zwar genügend hohe Flammpunkte; ihr Einsatz als Auswaschlösung wird durch ihren intensiven, oft reizenden Geruch eingeschränkt.

Aufgabe der vorliegenden Erfindung war es deshalb, ein Auswaschmittel zu finden, dessen Flammpunkt deutlich über Raumtemperatur liegt, das nur eine geringe Auswaschzeit für Flexodruckplatten benötigt, nur eine geringfügige Quellung der Druckform verursacht, geringe Toxizität sowie nur geringen bzw. angenehmen Geruch aufweist.

Überraschenderweise wurde gefunden, daß diese Eigenschaften mit Auswaschmitteln erfüllt werden können, die als Kohlenwasserstofflösungsmittel bestimmte hydrierte Erdölfraktionen enthalten.

Gegenstand der vorliegenden Erfindung ist ein Verfahren zum Entwickeln von bildmäßig belichteten Flexodruckplatten, wobei die unbelichteten Bereiche mit Kohlenwasserstofflösungsmitteln oder Gemischen davon mit Alkoholen ausgewaschen werden, das dadurch gekennzeichnet ist, daß sie als Kohlenwasserstofflösungsmittel hydrierte Erdölfraktionen enthalten, die Flammpunkte > 45°C und Siedebereiche zwischen 160 und 220°C aufweisen.

Bevorzugt sind solche hydrierten Erdölfraktionen, die einen Aromatengehalt nach DIN 51 378 von < 1 % aufweisen, bzw. solche die einen naphthenischen Anteil - ebenfalls nach DIN 51 378 bestimmt - zwischen 0,5 und 50 % aufweisen.

Die für das erfindungsgemäße Verfahren einzusetzenden Auswaschmittel können auch Zusätze von Geruchsverbesserern und/oder oberflächenaktiven Stoffe enthalten.

Aromatenhaltige Kohlenwasserstofflösungsmittel (Aromatenanteil > 10 %) eignen sich zwar ebenfalls als Auswaschmittel für Druckplatten, sie haben aber deutlich niedrigere OEL-Werte und einen unangenehmen Geruch.

Rein paraffinische Lösungsmittel, wie z.B. die synthetischen Isoparaffine, eignen sich dagegen kaum zum Auswaschen von Flexodruckplatten. Dasselbe gilt auch für hochsiedende n-Paraffingemische.

Entaromatisierte Kohlenwasserstofflösungsmittel mit einem Siedebereich oberhalb 230°C sind aufgrund zu hoher Auswaschzeiten ebenfalls nicht als Auswaschmittel für Flexodruckplatten geeignet.

Erfindungsgemäß bevorzugte hydrierte Erdölfraktionen sind insbesondere solche, die neben einem Aromatengehalt von < 1 % und einem Flammpunkt von > 45°C einen Siedebereich von 170 bis 220°C, insbesondere 180 bis 210°C, und einen Anteil an naphthenischen Kohlenwasserstoffen von 0,5 bis 50, insbesondere 10 bis 40 %. (nach DIN 51 378) aufweisen.

Beispiele für geeignete hydrierte Erdölfraktionen sind Shellsol®D 60 der Fa. Shell und Exxsol®D 60 der Fa. Esso, die einen Siedebereich von etwa 180 bis 210°C, einen Flammpunkt von ca. 60°C, einen Aromatengehalt von 0,5 %, sowie einen Gehalt an naphthenischen Kohlenwasserstoffen von ca. 30 % aufweisen. Diese Produkte sind zudem fast vollständig geruchsfrei und weisen hohe OEL-Werte (OEL = occupationl exposure limit) auf.

Da Flexodruckplatten im allgemeinen einen mehrschichtigen Aufbau besitzen (auf der ca. 3000 µm starken Reliefschicht befindet sich häufig eine dünne, ca. 5 µm starke Deckschicht aus Polyamid), kann es zweckmäßig sein, den erfindungsgemäß einzusetzenden hydrierten Erdölfraktionen eine Alkoholkomponente zuzufügen.

Als geeignet erwiesen sich hierzu Alkohole mit einer Kohlenstoffanzahl von 4 bis 8 (z.B. n-Butanol, n-Pentanol, iso-Butanol, Hexanol u.a.). Um eine ausreichende Löslichkeit der Polyamid-Deckschicht zu gewährleisten, sollte der Anteil der Alkoholkomponente mindestens 5 Vol.%, bevorzugt 20 Vol.%, betragen. Durch die Anwesenheit des Alkohols erniedrigt sich der Flammpunkt des reinen Kohlenwasserstofflösungsmittels um 10 bis 20°C. Die Flammpunkte der formulierten Auswaschlösungen liegen dann bei ca. 40°C. Die Auswaschlösungen können folglich in Geräten ohne EX-Schutz verarbeitet werden.

Wie bereits oben erwähnt, können die Auswaschlösungen noch oberflächenaktive Agentien, die die Auflösung des nicht belichteten Materials beschleunigen, und Anteile von geruchsverbessernden Substanzen enthalten.

Als oberflächenaktive Substanzen kommen beispielsweise Alkylsulfonate und deren Salze, Alkylammoniumsalze oder ethoxylierte Fettalkohole, Fettalkoholethersulfate und ihre Salze sowie Fettalkoholphosphorsäureester und deren Salze in Frage. Die oberflächenaktiven Komponenten können der Auswaschlösung üblicherweise in einer Menge von 0 bis 2 Gew.% zugesetzt werden.

Als geruchsverbessernde Zusatzstoffe kommen beispielsweise die in der Natur vorkommenden terpenoiden Verbindungen, Limonen, Pinen, Citronellol, etc. in Frage. Diese können der Auswaschlösung je nach der gewünschten Intensität des aromatischen Geruchs in einem Anteil von 0 bis max. 10 Gew.%, zugegeben werden.

Das Entwickeln und Auswaschen der bildmäßig belichteten photopolymeren Schichten erfolgt in üblicher Weise in den bekannten Sprüh-, Bürsten- und Reibewaschern bei Temperaturen von 20 bis 50°C. Dabei zeigt es sich, daß die für eine bestimmte Auswaschtiefe notwendige Auswaschzeit im Falle der erfindungsgemäßen Auswaschlösungen nur unwesentlich höher ist als im Falle der gängigen Auswaschmittel, daß aber die Lösungsmittelaufnahme der belichteten Teile der Reliefschicht im Falle der erfindungsgemäßen Auswaschlösungen drastisch verringert wird. Dadurch verbessert sich die Überwaschresistenz der durch bildmäßige Belichtung erzeugten Strukturen ganz erheblich, d.h. auch wenn die für eine bestimmte Reliefhöhe notwendige Auswaschzeit überschritten wird, werden fehlerfreie Strukturen erhalten.

Auch die Ausbruchstabilität der durch bildmäßige Belichtung erzeugten Strukturen wird durch die erfindungsgemäße Verwendung der oben beschriebenen hydrierten Erdölfraktionen erheblich verbessert. Dies ist von besonderer Bedeutung bei dicken weichelastischen Druckplatten mit hohem Relief (ca. 3 mm), die beispielsweise im Kartonagen- und Wellpappendruck eingesetzt werden.

Ein weiterer überraschender Vorteil der erfindungsgemäß einzusetzenden Auswaschlösungen betrifft die Oberflächengüte der bildmäßig belichteten und ausgewaschenen Schichten. Insbesondere beim Auswaschen von Flexodruckplatten in den gängigen Flexolösemitteln kommt es oft zu einer unerwünschten Oberflächenstruktur in Form von Runzeln (die sogenannte Orangenhaut), die beim Auswaschen in den erfindungsgemäßen Lösemitteln nicht beobachtet werden, so daß die erfindungsgemäß hergestellten Reliefformen eine gleichmäßig glatte Oberfläche aufweisen.

Ein weiterer überraschender Vorteil der erfindungsgemäß zu verwendenden Auswaschlösungen ist die Tatsache, daß trotz des hohen Siedebereiches der in Rede stehenden hydrierten Erdölfraktionen im Vergleich zu den Auswaschlösungen mit Tetrachlorethylen keine verlängerten Trocknungszeiten nach dem Auswaschen notwendig sind.

Vorteilhaft ist ferner, daß die Auswaschmittel gemäß vorliegender Erfindung in nicht-explosionsgeschützten Auswaschgeräten eingesetzt werden können. Aufgrund des geringen Eigengeruchs der erfindungsgemäß einzusetzenden hydrierten Erdölfraktionen kann die Absaugung der Auswaschgeräte stark reduziert werden. Nach der Fertigstellung sind die Reliefformen geruchlos.

Vorteilhaft ist weiterhin die Tatsache, daß die erfindungsgemäß einzusetzenden Auswaschlösungen an zahlreichen bekannten, durch Photopolymerisation vernetzbaren Schichten mit Erfolg angewandt werden können.

So ergeben sich beispielsweise kurze Auswaschzeiten bei photopolymerisierbaren Schichten, die als Bindemittel Vinylaromat/Alkadienblockmischpolymerisate (Styrol-Isopren-Styrol, Styrol-Butadien-Styrol, Styrol-Isopren-Styrol/Butadien, etc.) enthalten, sowie bei Schichten, die als Bindemittel Alkadien/Acrylnitrilcopolymerisate (Butadien-Acrylnitril), Fluorkautschuke (Vinylidenchlorid-Hexafluorpropylencopolymerisate), Naturkautschuk, Siliconpolymerisate und Polysulfidkautschuke enthalten. Kurze Auswaschzeiten ergeben sich ferner an Aufzeichnungsmaterialien, die als Bindemittel Ethylen-Propylen-Dien-Terpolymere enthalten.

Die Vorteile der erfindungsgemäßen Auswaschmittel für Flexodruckplatten werden in den folgenden Beispielen und Vergleichsbeispielen erläutert.

Die verwendeten Rohschichten hatten die folgenden Zusammensetzungen (Anteile in Gew.-%)

1. Plattentyp 1 (Einschichtenplatte)

```
3-Blockkautschuk aus Styrol/Isopren/Styrol-Butadien      87.592 %
gemäß EP-A-27 612, Beispiel 2
Paraffinöl                                                   5 %
Hexandioldiacrylat                                          5 %
Benzildimethylketal                                        1.2 %
2,6-Di-tert.-butyl-p.-kresol                               1.2 %
Farbstoff Solvent Black (C.I. 26 150)                    0.008 %
```

Schichtstärke 2700 μm auf einer 125 μm starken Polyethylenterephthalatfolie, die mit einem Polyurethanhaftlack beschichtet wurde.

2. Plattentyp 2 (Mehrschichtenplatte)

```
3-Blockkautschuk wie bei Plattentyp 1                    93.596 %
Hexandioldiacrylat                                          5 %
Benzildimethylketal                                        0.4 %
2,6-Di-tert.-butyl-p-kresol                               1.0 %
Farbstoff Solvent Black (C.I. 26 150)                    0.004 %
```

Schichtstärke 700 μm auf einer 125 μm starken Polyethylenterephthalatfolie, die mit einem Polyurethanhaftlack beschichtet war. Als Trägerschicht wurde eine photovernetzbare Schicht ebenfalls auf Basis eines elastomeren Bindemittels eingesetzt (Stärke 2000 μm).

3. Plattentyp 3

```
Terpolymer aus Ethylen/Propylen/Ethyliden-               78 %
norbornen (Anteile 50 % Ethylen; 8 Doppelbindungen
je 1000 C-Atome)
Dioctyladipat                                            10 %
Dihydrocyclopentadienylacrylat                            6 %
Isobornylacrylat                                          4 %
Benzildimethylketal                                       2 %
```

Schichtstärke 2700 μm auf einer 125 μm starken Polyethylenterephthalatfolie, die mit einem Polyurethanhaftlack beschichtet wurde.

Beispiel 1

Es wurde eine Flexoplatte (Plattentyp 1) in üblicher Weise hergestellt.

Die Flexodruckplatte wurde zunächst während 65 Sekunden von der Rückseite her in einem Röhrenbelichter vollflächig vorbelichtet, anschließend durch eine Negativauflage hindurch stufenweise bildmäßig belichtet (Belichtungszeiten pro Nutzen des Negativs von 5 bis 20 Minuten) und bei Raumtemperatur in einem nicht explosionsgeschützten Bürstenwascher mit geringer Luftabsaugung (ca. 10 m³/h) ausgewaschen. Der Wascher enthielt eine Auswaschlösung aus 80 Vol.-Teilen einer hydrierten Erdölfraktion (Naphthengehalt 35 %, Siedebereich 186 bis 217°C) und 20 Vol.-Teilen n-Butanol.

Für eine gewünschte Reliefhöhe von 700 µm betrug die optimale Auswaschzeit 6 Minuten.

Schon bei 6-minütiger Belichtungszeit waren alle Testelemente der erhaltenen Flexodruckform vollständig und korrekt ausgebildet.

Die Flexodruckform wurde 2 Stunden bei 65°C getrocknet, während 15 Stunden bei Raumtemperatur gelagert, einer üblichen Nachbehandlung mit einer wäßrigen Bromlösung unterzogen und erneut getrocknet.

Die Druckform wies nach der Fertigstellung eine gleichmäßig glatte Oberfläche auf. Es konnte keine Orangenhaut beobachtet werden. Die Druckform war nach der Herstellung geruchlos.

Die nachbehandelte Flexodruckform wurde auf einen Druckzylinder in einem Flexodruckwerk aufgespannt und lieferte ausgezeichnete Druckergebnisse, die keinerlei Informationsverlust gegenüber der Negativvorlage aufwiesen.

Beispiel 2

Es wurde wie in Beispiel 1 verfahren, nur wurde der Auswaschlösung als Alkoholkomponente anstatt n-Butanol n-Pentanol (Anteil 20 Vol.-Teile) zugesetzt. Die Auswaschversuche wurden wiederum in einem nicht explosionsgeschützten Bürstenwascher mit geringer Absaugung (ca. 10 m³/Stunde) durchgeführt.

Die optimale Auswaschzeit betrug 6 Minuten. Alle Testelemente waren schon bei einer Belichtungszeit von 6 Minuten vollständig und korrekt ausgebildet.

Nach der Nachbehandlung wies die Druckform wiederum eine gleichmäßig, glatte Oberfläche und gute Druckeigenschaften auf und war geruchsfrei.

Vergleichsbeispiel 1

Es wurde wie in Beispiel 1 verfahren, nur wurde als Auswaschlösung eine Mischung aus 80 Vol.-Teilen Tetrachlorethylen und 20 Vol.-Teilen n-Butanol verwendet.

Die Auswaschversuche wurden in einem nicht explosionsgeschützten, aber mit einer starken Luftabsaugung (ca. 100 m³/h) versehenen Bürstenwascher durchgeführt.

Die optimale Auswaschzeit betrug 5 Minuten. Die Testelemente waren erst nach einer Belichtungszeit von >12 Minuten fehlerfrei ausgebildet. Bei kürzeren Belichtungszeiten wurden an den Testelementen, insbesondere an Gitter- und Rasterfeldern, Ausbrüche festgestellt.

Nach dem Trocknen und der Nachbehandlung wiesen die Druckformen eine ungleichförmige strukturierte Oberfläche (Orangenhaut) auf.

Vergleichsbeispiel 2

Es wurde wie in Beispiel 1 verfahren, nur wurde als Auswaschlösung eine Mischung aus 80 Vol.-Teilen Testbenzin (Aromatengehalt 25 %, Siedebereich 187 bis 216°C) und 20 Vol.-Teilen n-Butanol eingesetzt. Die Auswaschversuche wurden in einem nicht explosionsgeschützten Wascher mit starker Absaugung (ca. 100 m³/h) durchgeführt.

Die optimale Auswaschzeit betrug 5 Minuten. Die Druckformen besaßen nach ihrer Fertigstellung einen unangenehmen Geruch.

Vergleichsbeispiel 3

Es wurde wie in Beispiel 1 verfahren, nur wurde als Auswaschlösung eine Mischung aus 80 Vol.-Teilen Testbenzin (Aromatengehalt 25 %, Siedebereich 155 bis 185°C) und 20 Vol.-Teilen n-Butanol eingesetzt. Die Versuche wurde in einem explosionsgeschützten Wascher mit starker Absaugung (ca. 100 m³/h) durchgeführt.

Die optimale Auswaschzeit für ein 700 µm Relief betrug 6 Minuten. Die Druckformen besaßen nach ihrer Fertigstellung einen unangenehmen Geruch.

Vergleichsbeispiel 4

Es wurde wie in Beispiel 1 verfahren, nur wurde als Auswaschmittel eine Mischung aus 80 Vol.-Teilen eines hydrierten Mineralöles (Siedebereich 220 bis 255°C, naphthenischer Anteil ca. 30 %) und 20 Vol.-Teilen n-Butanol eingesetzt. Die Versuche wurde in einem nicht explosionsgeschützten Bürstenwascher mit geringer Absaugung (ca. 10 m³/h) durchgeführt.

Die Auswaschzeit für ein 700 μm starkes Relief betrug 17 Minuten.

Beispiel 3

Es wurde wie in Beispiel 2 verfahren, nur wurde anstelle des Plattentyps 1 der mehrschichtige Plattentyp 2 mit einer festgelegten Reliefhöhe von 700 μm eingesetzt. Die Versuche wurden in einem nicht explosionsgeschützten Wascher mit geringer Absaugung (ca. 10 m³/h) durchgeführt.

Die optimale Auswaschzeit betrug 6 Minuten. Bei einer 100 %igen Überwaschung, d.h. bei einer gesamten Auswaschzeit von 12 Minuten, konnten keine Schäden an der Reliefstruktur oder fehlende Testelemente beobachtet werden. Die Druckformen waren geruchsfrei.

Vergleichsbeispiel 5

Es wurde wie in Beispiel 3 verfahren, nur daß nun eine Auswaschlösung aus 80 Vol.-Teilen Tetrachlorethylen und 20 Vol.-Teilen n-Butanol verwendet wurde. Die Versuche wurden in einem nicht explosionsgeschützten Wascher mit starker Absaugung (ca. 100 m³/h) durchgeführt.

Die optimale Auswaschzeit betrug 5 Minuten. Eine 100 %ige Überwaschung machte sich jetzt im Fehlen kritischer Testelemente (freistehende Punkte und Linien) und in Ausbrüchen an Rasterfeldern und Gittern bemerkbar.

Beispiel 4

An einem wie in Beispiel 1 hergestellten Klischee vom Plattentyp 1 wurde der Trocknungsverlauf in Abhängigkeit von der Zeit in einem Umlufttrockenschrank bei 65°C ermittelt.

Direkt nach dem Auswaschen betrug die Gewichtsquellung 2 %. Nach einer Trocknungsdauer von 2 Stunden bei 65°C war die Gewichtsquellung auf -0,1 % des Ausgangsgewichtes zurückgegangen. Der nach einer Trocknungsdauer von 24 Stunden ermittelte extrahierte Anteil betrug 0,3 %, bezogen auf das Ausgangsgewicht.

Vergleichsbeispiel 6

Es wurde wie in Beispiel 4 verfahren, nur wurde als Auswaschlösemittel eine Mischung aus 80 Vol.-Teilen Tetrachlorethylen und 20 Vol.-Teilen n-Butanol eingesetzt.

Direkt nach dem Auswaschen betrug die Gewichtsquellung 8 %. Nach einer Trocknungsdauer von 2 Stunden war die Gewichtsquellung zwar ebenfalls auf -0,1 % zurückgegangen, der extrahierte Anteil betrug aber 1,7 %, bezogen auf das Ausgangsgewicht.

Beispiel 5

Als Flexodruckplatte wurde der Plattentyp 3 eingesetzt. Nach der rückseitigen Vorbelichtung wurde die Druckplatte von der Vorderseite durch ein Testnegativ bildmäßig belichtet (Belichtungszeit 20 Minuten) und anschließend in einem Bürstenwascher zum Klischee entwickelt. Als Auswaschlösung wurde eine Mischung aus 80 Vol.-Teilen einer hydrierten Erdölfraktion (Naphthengehalt 35 %, Paraffingehalt 65 %, Siedebereich 186 bis 217°C, Aromatengehalt <1 % nach DIN 51 378) und 20 Vol.-Teilen n-Butanol eingesetzt.

Die für eine Reliefhöhe von 700 μm optimale Auswaschzeit betrug 12 Minuten. Sämtliche Testelemente waren einwandfrei und korrekt ausgebildet. Nach der Nachbehandlung wurden Klischees erhalten, die eine gleichförmig glatte Oberfläche aufwiesen.

Vergleichsbeispiel 7

Es wurde wie in Beispiel 5 verfahren, nur wurde als Auswaschmittel eine Mischung aus 80 Vol.-Teilen Tetrachlorethylen und 20 Vol.-Teilen n-Butanol eingesetzt.

Die für eine Reliefhöhe von 700 μm optimale Auswaschzeit betrug wiederum 12 Minuten. An Kanten und in Rasterfeldern wurden Ausbrüche festgestellt. Nach der Nachbehandlung wurden Klischees erhalten, die eine ungleichmäßige, zerstörte Oberfläche aufwiesen.

Beispiel 6

Es wurde wie in Beispiel 1 verfahren, nur wurde als Auswaschlösung eine Mischung aus 75 Vol.-Teilen einer hydrierten Erdölfraktion (Siedebereich 160 bis 195°C, Naphthengehalt 35 %), 20 Vol.-Teilen n-Butanol und 5 Vol.-Teilen Limonen eingesetzt.

Die Auswaschversuche wurden an einem nicht explosionsgeschützten Bürstenwascher mit geringer Absaugung (ca. 10 m³/h) durchgeführt. Die optimale Auswaschzeit für ein 700 μm Relief betrug 5 Minuten. Die Klischess wiesen einen angenehmen orangenartigen Geruch auf.

**Patentansprüche**

1. Verfahren zum Entwickeln von bildmäßig belichteten Flexodruckplatten, wobei die unbelichteten Bereiche mit Kohlenwasserstofflösungsmitteln oder Gemischen davon mit Alkoholen ausgewaschen werden, dadurch gekennzeichnet, daß sie als Kohlenwasserstofflösungsmittel hydrierte Erdölfraktionen enthalten, die Flammpunkte > 45°C und Siedebereiche zwischen 160 und 220°C aufweisen.

2. Verfahren nach Anspruch 1, dadurch gekennzeichnet, daß die hydrierten Erdölfraktionen einen Aromatengehalt nach DIN 51 378 von < 1 % aufweisen.

3. Verfahren nach Anspruch 1 oder 2, dadurch gekennzeichnet, daß die hydrierten Erdölfraktionen einen naphthenischen Anteil nach DIN 51 378 zwischen 0,5 und 50 % aufweisen.

4. Verfahren nach Anspruch 1 bis 3, dadurch gekennzeichnet, daß die hydrierten Erdölfraktionen einen Zusatz eines Geruchsverbesserers und/oder eines oberflächenaktiven Stoffes enthalten.

5. Verfahren nach einem der Ansprüche 1 bis 4, dadurch gekennzeichnet, daß die bildmäßig belichteten Flexodruckplatten aus einem lichtempfindlichen Element gebildet werden, das als Bindemittel ein Vinylaromat/Alkadienblockmischpolymerisat enthält.

6. Verfahren nach einem der Ansprüche 1 bis 4, dadurch gekennzeichnet, daß die bildmäßig belichteten Flexodruckplatten aus einem lichtempfindlichen Element gebildet werden, das als Bindemittel ein Ethylen-Propylen-Dien-Terpolymer enthält.

**Claims**

1. A process for developing an imagewise exposed flexographic printing plate, the unexposed parts being washed out with a hydrocarbon solvent or a mixture thereof with an alcohol, wherein said hydrocarbon solvent is a hydrogenated mineral oil fraction which has a flashpoint of > 45°C and a boiling range of from 160 to 220°C.

2. A process as claimed in claim 1, wherein the hydrogenated mineral oil fraction has an aromatics content according to DIN 51 378 of < 1%.

3. A process as claimed in claim 1 or 2, wherein the hydrogenated mineral oil fraction has a naphthenic fraction according to DIN 51 378 of from 0.5 to 50%.

4. A process as claimed in any of claims 1 to 3, wherein the hydrogenated mineral oil fraction contains an added odor improver and/or an added surfactant.

5. A process as claimed in any of claims 1 to 4, wherein the imagewise exposed flexographic printing plate is formed from a photosensitive element which contains a vinylaromatic/alkadiene block copolymer as a binder.

6. A process as claimed in any of claims 1 to 4, wherein the imagewise exposed flexographic printing plate is formed from a photosensitive element which contains an ethylene/propylene/diene terpolymer as a binder.

**Revendications**

1. Procédé pour développer des plaques d'impression flexographique exposées selon une image, les zones non exposées étant lavées avec des solvants hydrocarbures ou des mélanges de ceux-ci avec des alcools, caractérisé par le fait qu'ils contiennent, comme solvants hydrocarbures, des fractions d'huiles minérales hydratées qui ont des points d'inflammation supérieurs à 45°C et des zones d'ébullition comprises entre 160 et 220°C.

2. Procédé selon la revendication 1, caractérisé par le fait que les fractions d'huiles minérales hydratées ont une teneur en aromates selon DIN 51378 inférieure à 1 %.

3. Procédé selon l'une des revendications 1 ou 2, caractérisé par le fait que les fractions d'huiles minérales hydratées ont une partie naphténique, selon DIN 51378, comprise entre 0,5 et 50 %.

4. Procédé selon l'une des revendications 1 à 3, caractérisé par le fait qu'ils contiennent une addition d'un correcteur d'odeur et/ou d'un produit tensio-actif.

5. Procédé selon l'une des revendications 1 à 4, caractérisé par le fait que les plaques d'impression flexographique exposées selon une image sont formées d'un élément sensible à la lumière, qui contient, comme liant, un copolymérisat en bloc vinylaromate/alcadiène.

6. Procédé selon l'une des revendications 1 à 4, caractérisé par le fait que les plaques d'impression flexographique exposées selon une image sont formées d'un élément sensible à la lumière, qui contient, comme liant, un terpolymère éthylène-propylène-diène.